# FASCICULE DE BREVET EUROPEEN

(11) **EP 2 223 583 B1**
(45) Date de publication et mention de la délivrance du brevet: **28.11.2012**
(21) Numéro de dépôt: 08863273.2
(22) Date de dépôt: 18.12.2008
(51) Int. Cl.: H05K 7/20, H05K 7/14

(54) **DISPOSITIF DE REFROIDISSEMENT D'UNE CARTE ELECTRONIQUE PAR CONDUCTION A L'AIDE DE CALODUCS, ET PROCEDE DE FABRICATION CORRESPONDANT.**
VORRICHTUNG ZUR KÜHLUNG EINER ELEKTRONIKKARTE MITTELS LEITUNG MIT HEIZROHREN UND ENTSPRECHENDES HERSTELLUNGSVERFAHREN
DEVICE FOR COOLING AN ELECTRONIC CARD BY CONDUCTION COMPRISING HEAT PIPES, AND CORRESPONDING METHOD OF FABRICATION

(30) Priorité: 18.12.2007 FR 0708833
(43) Date de publication de la demande: 01.09.2010
(73) Titulaire: THALES, 92200 Neuilly-sur-Seine (FR)
(72) Inventeur: TISSOT, Serge, F-83400 Hyeres (FR); DEMONCHAUX, Thierry, F-83400 Hyeres (FR); OCONTE, Philippe, F-83136 Rocbaron (FR); VANNEUVILLE, Guy, F-83390 Pierrefeu du Var (FR)
(74) Mandataire: Lucas, Laurent Jacques
(86) Numéro de dépôt international: PCT/EP2008/067929
(87) Numéro de publication internationale: WO 2009/077601

(56) Documents cités:
- EP-A- 1 853 097
- US-A1- 2003 128 508
- US-A1- 2004 120 116
- US-A1- 2005 122 686
- US-A1- 2007 171 616

## Description

L'invention porte sur le refroidissement des cartes électroniques, en particulier le refroidissement des cartes électroniques par conduction. Cette méthode de refroidissement consiste à évacuer la chaleur de la carte électronique directement vers un autre corps en contact avec elle-même.

Divers éléments peuvent permettre de refroidir une carte électronique et ses composants. Par exemple, il est possible de fixer un drain thermique sur tout ou une partie de la carte électronique, de façon à évacuer la chaleur produite par la carte vers l'extérieur comme le châssis dans lequel la carte électronique peut être encastrée.

Toute carte électronique comprend des points ayant une température plus élevée que le reste de la carte. Ces points chauds correspondent aux endroits où se trouvent certains composants, par exemple des processeurs. Pour améliorer l'évacuation de la chaleur de ces points chauds, il est possible d'utiliser des caloducs. Ces derniers sont de longs cylindres métalliques (par exemple en cuivre ou en aluminium) renfermant un fluide tel que de l'eau.

Cette eau se trouve en équilibre entre sa phase gazeuse et sa phase liquide, en absence de tout autre gaz. Dans la portion du caloduc se situant près du composant à refroidir, l'eau chauffe et se vaporise en emmagasinant de l'énergie provenant de la chaleur émise par ce composant.

Ce gaz remonte alors le caloduc pour arriver près d'un système de refroidissement où il sera refroidi, jusqu'à ce qu'il se condense pour redevenir à nouveau un liquide, et céder de l'énergie à l'air ambiant sous forme de chaleur.

Un exemple de solution incorporant un caloduc est décrit dans le document US 6.839.235. Il est présenté en ensemble caloduc/drain thermique où chaque caloduc est fixé à une extrémité du drain thermique à l'aide d'une soudure en étain ou encore d'un adhésif thermiquement conducteur. Cette fixation ente les caloducs et le drain thermique entraîne une dépendance entre les deux éléments tant du point de vue thermique que mécanique.

La dépendance thermique implique une mauvaise évacuation de la chaleur des composants de la carte électronique. En effet, les calories évacuées des points chauds s'additionnent aux calories des autres composants de la carte électronique, ces dernières étant évacuées via le drain thermique. Cette dépendance thermique ralentit fortement l'évacuation de la chaleur.

La dépendance mécanique entre le drain et les caloducs rend difficile la fabrication du dispositif de refroidissement en série, du fait d'une fixation nécessaire entre les caloducs et le drain thermique.

L'invention vise à apporter une solution à ces problèmes.

Un but de l'invention est de proposer un dispositif de refroidissement permettant d'améliorer l'évacuation de la chaleur des points chauds d'une carte électronique.

Un autre but de l'invention et de proposer un procédé de fabrication d'un tel dispositif de refroidissement.

A cet effet, il est proposé un dispositif de refroidissement d'une carte électronique comportant au moins un composant recouvert d'un capot protecteur, le dispositif comprenant un drain thermique recouvrant tout ou une partie de la carte électronique, et au moins un caloduc par composant, chaque caloduc étant apte à évacuer la chaleur du composant auquel il est associé, vers au moins une extrémité de la carte électronique via une zone du caloduc dite de condensateur.

Selon une caractéristique générale de cet aspect, ledit dispositif comprend au moins une pièce d'échange thermique localisée sur ladite extrémité de la carte électronique et montée librement sur le drain thermique, chaque caloduc étant fixé sur la pièce d'échange thermique par l'intermédiaire de sa zone de condensateur.

En d'autres termes, les extrémités des caloducs sont maintenues aux extrémités de la carte électronique par l'intermédiaire d'une pièce d'échange thermique. Aucun caloduc n'est donc fixé au drain thermique.

Cette indépendance entre le drain thermique et le(s) caloduc(s) permet une meilleure évacuation de la chaleur des composants de la carte électronique, ces composants étant généralement les points les plus chauds de la carte électronique. En effet, on limite grâce au dispositif proposé, le mélange des calories provenant d'une part des composants (calories évacuées par les caloducs) et d'autre part du reste de la carte électronique (calories évacuées par le drain thermique).

Par exemple, la pièce d'échange thermique peut être montée sur le drain thermique à l'aide de plots.

Selon un mode de réalisation, la pièce d'échange thermique et la portion du drain thermique qu'elle recouvre peuvent former une glissière thermique, apte à être introduite dans un rail de guidage monté sur un châssis externe à la carte.

De préférence, un système de verrouillage peut être monté sur chaque glissière thermique, chaque système de verrouillage étant décomposé en au moins une partie fixe et au moins une partie mobile, lesdites parties fixes étant formées à partir du drain thermique.

De préférence, chaque composant est associé à au moins deux caloducs, répartis de part et d'autre du composant.

Par exemple, chaque composant peut être associé à au moins deux caloducs, disposés du même côté du composant.

Par exemple au moins deux caloducs associés à un même composant sont orientés dans deux directions opposées selon un premier axe.

De préférence, au moins deux caloducs associés à un même composant comprennent chacun une déformation en forme de L, une branche du L étant sensiblement parallèle à l'extrémité de la carte électronique où est localisée la pièce d'échange thermique, les courbures de la déformation de chaque caloduc étant orientées dans deux directions opposées selon un deuxième axe, parallèle à ladite extrémité de la carte électronique.

Plus précisément, au moins deux caloducs associés à un même composant ont une déformation en forme de U, les branches de chaque U étant sensiblement parallèles à l'extrémité de la carte électronique où est localisée la pièce d'échange thermique, les déformations des caloducs étant orientées dans deux directions opposées selon un deuxième axe, parallèle à ladite extrémité de la carte électronique.

De préférence, chaque capot échangeur est fixé au drain thermique à l'aide de n vis, et est maintenu à une distance choisie et fixée du composant auquel il est associé à l'aide de k contre-vis, n et k étant des entiers.

Selon un autre aspect, il est proposé un circuit électronique incorporant une carte électronique associée à un dispositif de refroidissement tel que décrit précédemment.

Selon un autre aspect, il est proposé un procédé de fabrication d'un dispositif de refroidissement tel que mentionné ci-avant.

Selon une caractéristique générale de cet autre aspect, il comprend une étape de fabrication du drain thermique et une étape de fabrication des caloducs, indépendante de l'étape de fabrication du drain thermique, puis une étape d'intégration du dispositif de refroidissement au sein du circuit électronique comprenant une fixation du drain thermique sur la carte électronique et un assemblage du drain thermique, des caloducs et des capots protecteurs.

Selon un mode de mise en oeuvre, l'assemblage du drain thermique, des caloducs et des capots protecteurs comprend pour chaque composant dudit ensemble, un montage du capot échangeur du composant considéré sur le drain thermique, le montage comportant pour chaque composant :
- un placement d'une cale sur ledit composant, la cale ayant une hauteur choisie et fixée correspondant à ladite distance à laquelle le capot échangeur est maintenu éloigné du composant,
- un placement du capot échangeur sur le composant correspondant, la cale étant intercalée entre le composant et le capot échangeur correspondant,
- un premier vissage des n vis, lesdites vis traversant le capot échangeur et une partie de l'épaisseur du drain thermique,
- un vissage des k contre-vis, lesdites contre-vis traversant le capot échangeur et s'appuyant sur le drain thermique,
- un dévissage des n vis puis un retrait du capot échangeur et de la cale,
- un dépôt d'une couche d'agent thermique au dessus du composant,
- un nouveau placement du capot échangeur au dessus du composant, l'agent thermique étant intercalé entre le composant et le capot échangeur correspondant,
- un deuxième vissage des n vis, plus serré que le premier vissage, les k contre-vis maintenant le capot échangeur à ladite distance choisie et fixée du composant.

Selon un nouvel aspect, il est proposé un dispositif de refroidissement d'une carte électronique comportant au moins un composant recouvert d'un capot protecteur, le dispositif comprenant un drain thermique recouvrant tout ou une partie de la carte électronique, et au moins un caloduc par composant, chaque caloduc étant apte à évacuer la chaleur du composant auquel il est associé, vers au moins une extrémité de la carte électronique via une zone du caloduc dite de condensateur. Ledit dispositif comprend au moins une pièce d'échange thermique localisée sur ladite extrémité de la carte électronique et fixée sur le drain thermique, par l'intermédiaire de sa zone de condensateur.

Le dispositif de refroidissement selon ce nouvel aspect peut comprendre un système de verrouillage monté sur chaque glissière thermique, chaque système de verrouillage étant décomposé en au moins une partie fixe et au moins une partie mobile, lesdites parties fixes étant formées à partir du drain thermique.

Le dispositif de refroidissement selon ce nouvel aspect, peut comprendre au moins deux caloducs associés à un même composant comprenant chacun une déformation en forme de L, une branche du L étant sensiblement parallèle à l'extrémité de la carte électronique où est localisée la pièce d'échange thermique, les courbures de la déformation de chaque caloduc étant orientées dans deux directions opposées selon un deuxième axe, parallèle à ladite extrémité de la carte électronique.

Plus précisément, le dispositif de refroidissement selon ce nouvel aspect, peut comprendre au moins deux caloducs associés à un même composant comprend une déformation en forme de U, les branches de chaque U étant sensiblement parallèles à l'extrémité de la carte électronique où est localisée la pièce d'échange thermique, les déformations des caloducs étant orientées dans deux directions opposées selon un deuxième axe, parallèle à ladite extrémité de la carte électronique.

Selon ce nouvel aspect, chaque capot échangeur est fixé au drain thermique à l'aide de n vis, et est maintenu à une distance choisie et fixée du composant auquel il est associé à l'aide de k contre-vis, n et k étant des entiers.

Il est également proposé un procédé de fabrication d'un dispositif de refroidissement selon ce nouvel aspect. Il comprend une étape de fabrication du drain thermique et des caloducs, puis une étape d'intégration du dispositif de refroidissement au sein du circuit électronique comprenant un assemblage du drain thermique, des caloducs et des capots protecteurs. Cet assemblage du drain thermique, des caloducs et des capots protecteurs peut comprendre pour chaque composant dudit ensemble, un montage du capot échangeur du composant considéré sur le drain thermique, le montage comportant pour chaque composant :
- un placement d'une cale sur ledit composant, la cale ayant une hauteur choisie et fixée correspondant à ladite distance à laquelle le capot échangeur est maintenu éloigné du composant,
- un placement du capot échangeur sur le composant correspondant, la cale étant intercalée entre le composant et le capot échangeur correspondant,
- un premier vissage des n vis, lesdites vis traversant le capot échangeur et une partie de l'épaisseur du drain thermique,
- un vissage des k contre-vis, lesdites contre-vis traversant le capot échangeur et s'appuyant sur le drain thermique,
- un dévissage des n vis puis un retrait du capot échangeur et de la cale,
- un dépôt d'une couche d'agent thermique au dessus du composant,
- un nouveau placement du capot échangeur au dessus du composant, l'agent thermique étant intercalé entre le composant et le capot échangeur correspondant,
- un deuxième vissage des n vis, plus serré que le premier vissage, les k contre-vis maintenant le capot échangeur à ladite distance choisie et fixée du composant.

D'autres avantages et caractéristiques de l'invention apparaîtront à l'examen de la description détaillée de modes de réalisation de l'invention et d'un mode de mise en oeuvre d'un procédé de fabrication de l'invention, nullement limitatifs, et des dessins annexés sur lesquels :
la figure 1 représente une carte électronique munie d'un dispositif de refroidissement, vue du dessus ;
les figures 2a à 2d représentent des vues en coupe, selon différents axes de la carte illustrée sur la figure 1, et en particulier, la zone de glissière aux extrémités de la carte électronique ;
les figures 3a et 3b représentent plus en détail un exemple de système de verrouillage monté sur les glissières de la carte électronique ;
les figures 4a à 4d représentent des vues en coupe, de la carte électronique représentée sur la figure 1, et en particulier un composant disposé sur la carte électronique ;
la figure 5 représente un mode de mise en oeuvre d'un procédé de fabrication d'un dispositif de refroidissement selon l'invention ; et
la figure 6 illustre plus en détail l'étape d'assemblage du drain thermique, des caloducs et des capots protecteurs des composants.

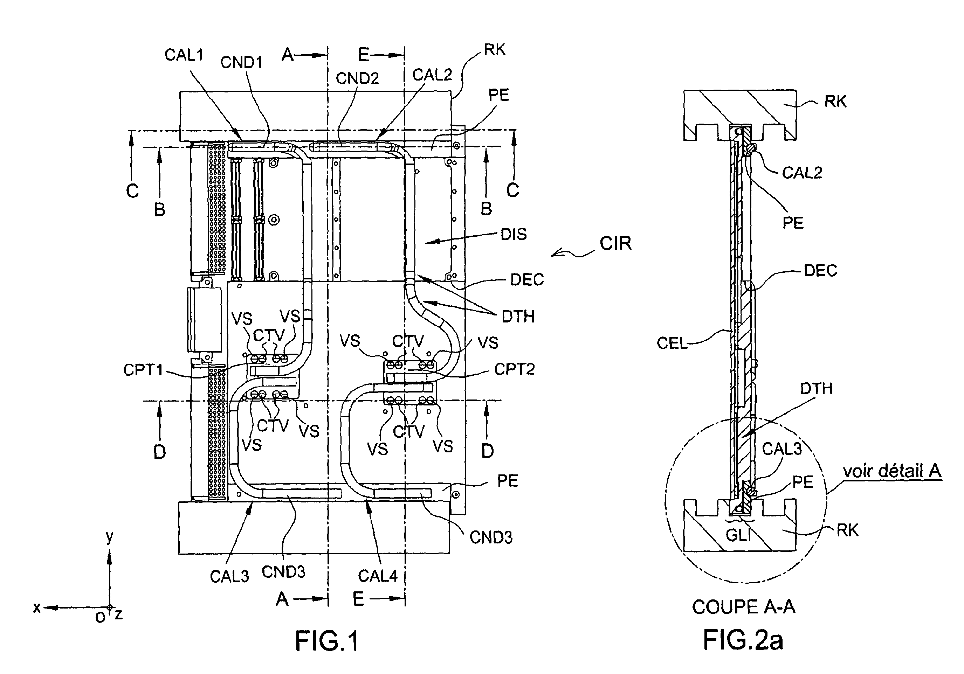

On se réfère à présent à la figure 1 et à la figure 2a qui illustre une coupe du circuit représenté sur la figure 1.

Sur cette figure 1 est représenté un circuit électronique CIR muni d'un dispositif de refroidissement de carte DIS. Celui-ci comporte une carte électronique CEL (visible sur la coupe 2a).

Sur la carte électronique CEL est disposé un drain thermique DTH. Dans cet exemple, le drain thermique DTH recouvre toute la carte électronique CEL, mais possède un décroché DEC où son épaisseur varie (comme illustré sur la figure 2a).

À certains endroits du drain thermique DTH, sont incrustés des capots protecteurs CPT1, CPT2. Ces derniers recouvrent des composants électroniques disposés sur la carte électronique CEL. Les capots protecteurs CPT1, CPT2 sont des éléments diffuseurs de chaleur. À cet effet, ils sont réalisés dans un matériau adapté, par exemple le cuivre.

Chaque capot échangeur CPT1, CPT2 a pour fonction de capter les calories produites par le composant au-dessus duquel il est disposé, et de les diffuser vers des caloducs. Cette architecture permet de refroidir plus rapidement la chaleur des composants (par exemple des processeurs) de la carte électronique, qui sont considérés comme des points chauds. En effet, si on prend l'exemple d'une carte électronique comprenant deux processeurs, et dissipant au total une puissance de 80W, 42W (soit plus de la moitié) proviennent des deux processeurs (2*21W).

Chaque capot échangeur CPT1, CPT2 est fixé au drain thermique DTH à l'aide de n vis VS, ici n est égal à 4. Par ailleurs, k contre-vis CTV (ici k est égal à 4) sont disposées sur chaque capot échangeur CPT1, CPT2. Le rôle de ces contre-vis CTV est décrit plus en détail ci-après.

De façon à évacuer la chaleur captée par les capots protecteurs CPT1, CPT2, des caloducs les relient aux extrémités de la carte électronique CEL. Dans cet exemple, deux caloducs sont associés à chaque composant via son capot protecteur, chacun des caloducs étant relié à l'une des extrémités de la carte électronique.

Les deux caloducs référencés CAL1 et CAL3 permettent d'évacuer la chaleur du composant disposé sous le capot échangeur CPT1, et les deux caloducs référencés CAL2 et CAL4 permettent d'évacuer la chaleur du composant disposé sous le capot échangeur CPT2. Chaque caloduc CAL1, CAL2, CAL3 et CAL4 comprend à son extrémité autre que celle placée au dessus du composant, une zone de condensateur respectivement CND1, CND2, CND3 et CND4. Ces zones de condensateur CND1, CND2, CND3 et CND4 sont fixées à une pièce d'échange thermique PE. Comme représenté sur la figure 1, les caloducs CAL1, CAL2, CAL3 et CAL4 cheminent (sans être fixés) dans des gorges aménagées dans le drain thermique DTH du capot échangeur CPT1, CPT2 jusqu'à la pièce d'échange thermique PE correspondante, pièce PE à laquelle ils sont fixés par l'intermédiaire de leur zone de condensateur CND1, CND2, CND3 et CND4.

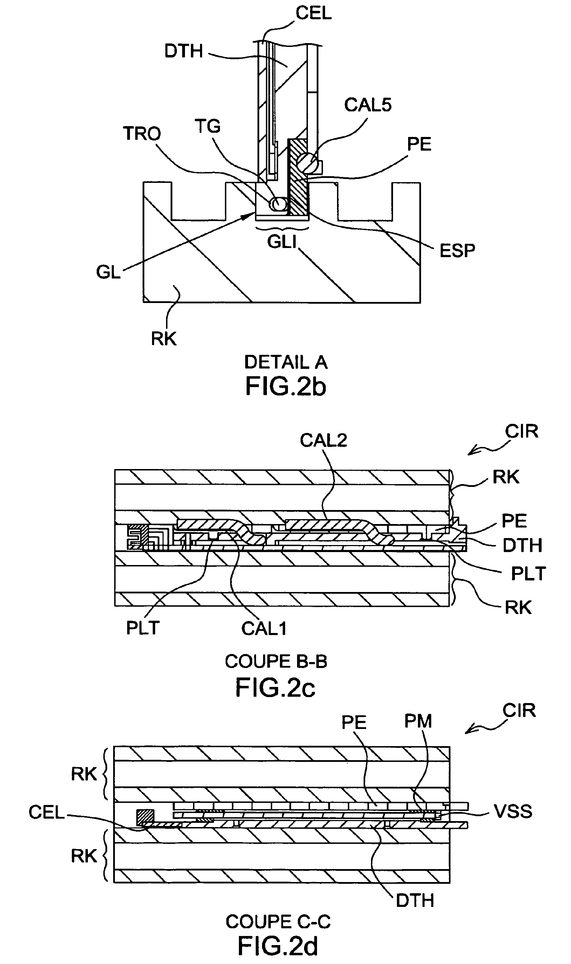

Sur cette figure, une pièce d'échange thermique PE est placée à chaque extrémité de la carte électronique CEL. Plus précisément, elle est montée librement sur le drain thermique DTH. Par exemple, la pièce d'échange thermique peut être simplement guidée par des plots PLT représentés sur la figure 2c. Les dimensions de ces plots PLT sont très inférieures à celles de la pièce d'échange thermique PE et du drain thermique DTH. Par conséquent, l'échange de calories entre ces deux éléments est négligeable par rapport aux autres transferts thermiques s'effectuant entre la carte électronique CEL et son dispositif de refroidissement DIS.

Elle est donc totalement indépendante du drain thermique DTH (mécaniquement) ainsi que de la carte électronique CEL.

Plus généralement, il est possible de n'associer qu'un seul caloduc par composant (comme décrit par exemple dans le document US 6.839.235), ou au contraire au moins deux caloducs par composant.

Dans un autre mode de réalisation, il est possible de remplacer chaque caloduc CAL1, CAL2, CAL3 et CAL4, par deux caloducs en parallèle mais ayant un diamètre plus fin que chacun des caloducs représenté sur la figure 1. Le doublement des caloducs permet d'augmenter la fiabilité du dispositif de refroidissement DIS. En effet, si l'un des caloducs tombe en panne où est dégradé, le caloduc placé parallèlement au caloduc défectueux assure l'évacuation de la chaleur du composant vers l'un des bords de la carte électronique.

Il est particulièrement intéressant d'orienter les deux caloducs associés à un même composant, dans deux directions opposées (+Y/-Y dans cet exemple) de façon à améliorer l'efficacité des caloducs. En effet, l'efficacité des caloducs (frittés ou autre) dépend de la gravité (ou accélération). La manière dont est positionné le circuit électronique CIR peut influer sur le fonctionnement des caloducs.

En orientant les caloducs d'un même circuit selon différentes positions, on s'assure que quelle que soit la position du circuit, au moins un caloduc est toujours fonctionne toujours de façon optimale quelque soit l'effet de l'accélération ou de la gravité.

Par ailleurs, du fait de leurs déformations orientées dans deux directions opposées, les caloducs référencés CAL1 et CAL2, seront les plus efficaces si le circuit subit une accélération selon la direction O/+Y.

Par contre, si le circuit subit une accélération selon l'axe O/-Y, ce seront les caloducs référencés CAL3 et CAL4 qui seront les plus efficaces.

Ainsi, il est particulièrement intéressant de courber chaque caloduc CAL1, CAL2, CAL3 et CAL4 en forme de U pour améliorer l'efficacité de ces derniers dans le cas où le circuit électronique CIR subit une accélération (plus simplement, il aurait aussi été possible de courber les caloducs en forme de L, sans les replier sur le composant). De façon à encore accroître l'efficacité des caloducs, il est préférable de courber les caloducs partant de part et d'autre d'un même composant CAL1 et CAL 3 d'une part et CAL2 et CAL4 d'autre part, dans des directions opposées, selon l'axe X/-X sur la figure 1.

Ces différentes orientations des caloducs peuvent être appliquées à un dispositif de refroidissement classique (par exemple celui décrit dans le document US 6.839.235), c'est-à-dire sans indépendance mécanique/thermique entre le drain thermique DHT et les caloducs.

On va s'attacher à présent à décrire plus en détail les bords de la carte électronique CEL, et la portion du dispositif de refroidissement à cet endroit. Comme on peut le voir sur la coupe de la figure 2a, le drain thermique DTH se prolonge sous la pièce d'échange thermique PE. Ils forment à eux deux une glissière thermique GLI.

Celle-ci peut être insérée dans un guide carte RK correspondant, réalisé sur un châssis externe au circuit électronique CIR. Ce guide carte RK est couramment appelée selon la dénomination anglo-saxonne de « card guide » par l'homme du métier.

Le guide carte RK est en contact avec la face supérieure de la pièce d'échange thermique PE. Ainsi, la chaleur des composants évacuée par les caloducs CAL1, CAL2, CAL3 et CAL4 est évacuée en direction du contact supérieur des glissières thermiques GLI avec le guide carte RK.

Par contre, la chaleur provenant des autres éléments de la carte électronique CEL est évacuée via la portion du drain thermique DTH formant la glissière thermique GLI, autrement dit la zone de contact inférieure de la glissière thermique GLI avec le guide carte RK.

Cette répartition permet de maintenir séparé les cheminements des calories et d'éviter ainsi que le reste de la carte électronique CEL ne réchauffe les points chauds et vice versa.

Comme illustré plus en détail sur la figure 2b (DETAIL A), la portion du drain thermique DTH formant la glissière thermique GLI est percée d'un trou oblong TRO traversé par une tige TG. Ce trou TRO ainsi que la portion du drain thermique DTH formant la glissière thermique GLI font partie d'un système de verrouillage SVER. Ce système de verrouillage SVER permet de solidariser la carte électronique et le guide carte dans laquelle elle a été glissée, à l'aide de vis de serrage VSS visibles sur la figure 2d.

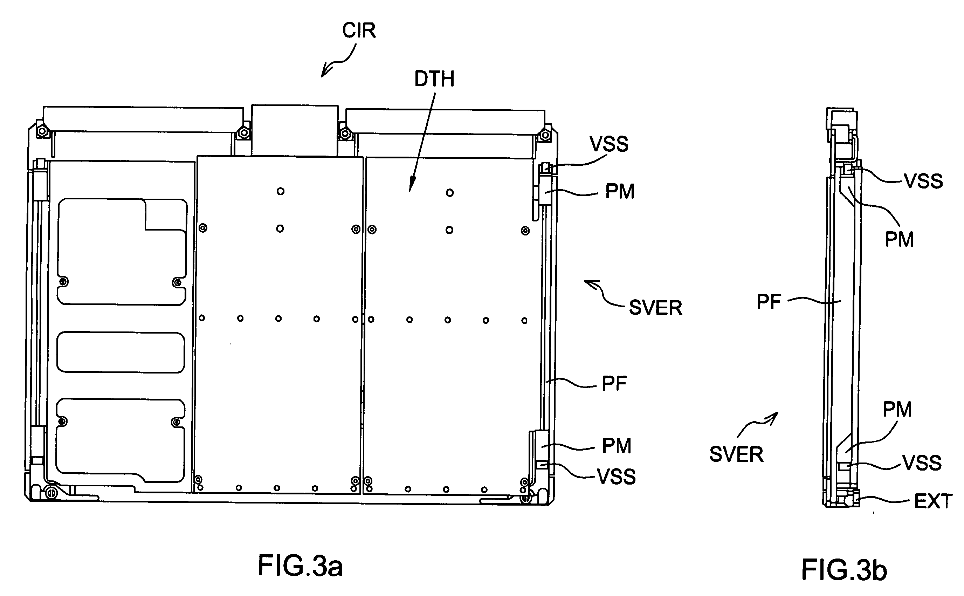

Le système de verrouillage SVER représenté plus en détail sur la figure 3a et la vue en coupe correspondante 3b. Ce système de verrouillage SVER est formé d'une partie fixe PF et de deux parties mobiles PM montées sur la tige TG précitée, et bloquées à l'aide de deux vis de serrage VSS. Ce système de verrouillage SVER monté dans des glissières est bien connu de l'homme du métier sous la dénomination anglo-saxonne de « wedgelock » ou « cardlock ». Par exemple le document « IEEE Standard 1101.2 for Mechanical Core Specifications for Conduction-Cooled Eurocards » publié en Août 1992 décrit un système dit « Wedgelock » classique.

Dans l'exemple illustré sur les figures 3a et 3b, la partie fixe PF du système de verrouillage SVER est formée dans le prolongement de drain thermique DTH. Le fait d'intégrer la partie fixe PF dans le drain thermique DTH améliore la rigidité du drain thermique DTH et augmente la section disponible pour évacuer les calories. Cela a également pour avantage de réduire la zone non-utilisable pour implanter des composants électroniques sur la carte électronique CEL.

L'incorporation de la partie fixe PF du système de verrouillage SVER au sein du drain thermique DTH peut être effectuée pour un dispositif de refroidissement classique compatible avec la norme IEEE Standard 1101.2.

On se réfère à nouveau à la figure 2b. La tige TG se déplace selon l'axe X/-X à l'intérieur du trou TRO de façon à bloquer la glissière thermique GLI à l'intérieur de l'encoche du « rack » RK. Lorsque la glissière thermique GLI est bloquée (telle qu'elle est représentée sur la figure 2b), un espace ESP localisé entre la pièce d'échange thermique PE et le drain thermique DTH, est réduit à sa valeur minimale. Cet espace ESP s'élargit lorsque l'on retire la glissière thermique GLI du rail de guidage RK.

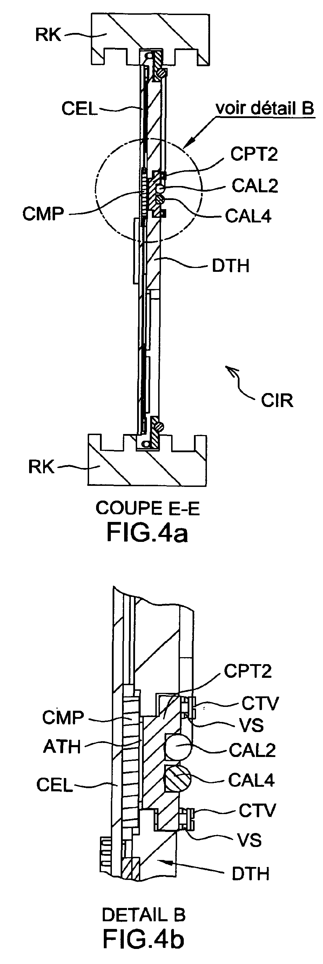

On se réfère à présent aux figures 4a à 4d qui illustrent plus précisément la zone du circuit électronique CIR où se situe un composant CMP.

La figure 4a est une vue en coupe du circuit électronique CIR selon un axe E-E. Sur cette coupe est visible le composant CMP, et plus particulièrement la zone de contact entre ce composant CMP et son capot échangeur CPT2. Cette zone de contact est représentée plus en détail sur la figure 4b (DETAIL B). Le capot échangeur CPT2 comprend deux ailettes latérales qui reposent sur le drain thermique DTH. La fixation entre le drain thermique DTH et des capots protecteurs sera expliquée plus en détail ci-après.

La partie centrale du capot échangeur CPT2 repose sur le composant CMP et plus précisément sur une couche d'agent thermique ATH déposée sur le composant CMP, sur la zone au-dessus de laquelle est placé le capot échangeur CPT2. Cet agent thermique ATH possède une grande conductivité thermique de façon à favoriser l'évacuation de la chaleur du composant CMP vers son capot échangeur CPT2. Par ailleurs, comme illustré sur le DETAIL B, les caloducs CAL2 et CAL4 sont situées dans des gorges aménagées dans le capot échangeur CPT2. Par exemple, les caloducs CAL2, CAL4 peuvent être soudés à l'intérieur de ces gorges.

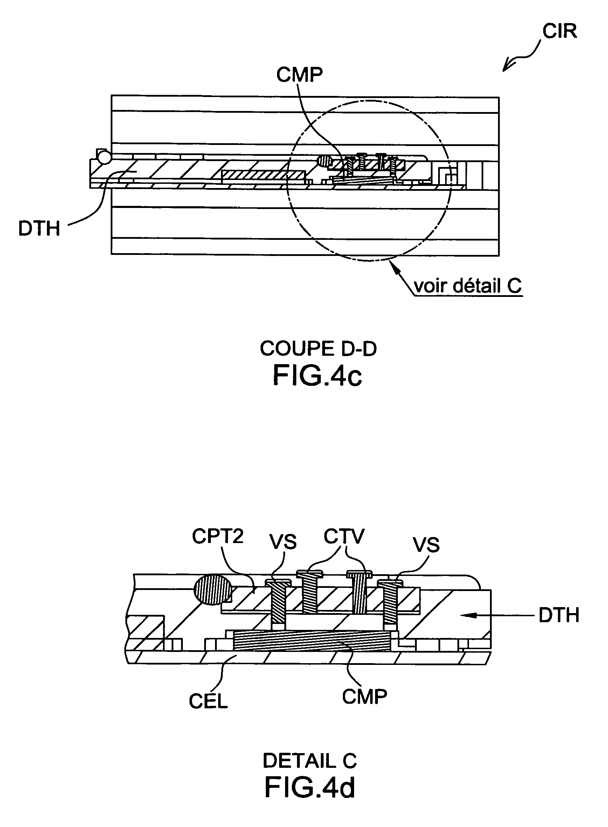

La figure 4c illustre une autre vue en coupe du circuit électronique CIR selon un axe D-D. Cette figure 4c permet de visualiser plus précisément la manière dont sont fixés ensemble le capot échangeur CPT2 et le drain thermique DTH. Bien entendu, cet exemple peut être reproduit sur les autres capots protecteurs du circuit électronique CIR.

La zone de contact entre le drain thermique DTH et le capot échangeur CPT2 est illustré plus en détail sur la figure 4d (DETAIL C).

Dans cet exemple, le capot échangeur CPT2 est traversé par 4 vis VS (deux sont visibles sur la figure 4d). Ces vis VS traversent également une portion du drain thermique DTH de façon à solidariser le capot échangeur CPT2 et le drain thermique DTH.

Par ailleurs, 4 contre-vis CTV (2 sont visibles sur la figure 4d) permettent de maintenir le capot échangeur CPT2 à une distance choisie du composant CMP. Ces contre-vis CTV traversent uniquement le capot échangeur CPT2, et le maintiennent éloigné d'une distance choisie du composant CMP. Cette distance peut par exemple être égale à 0,2mm.

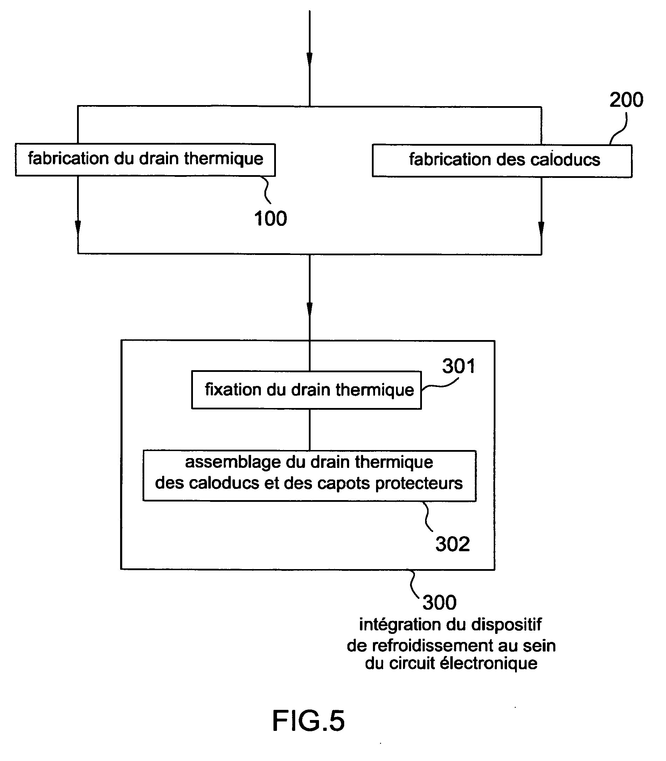

On se réfère à présent à la figure 5 qui illustre un mode de mise en oeuvre du procédé de fabrication du dispositif de refroidissement selon l'invention.

Ce mode de mise en oeuvre comprend en parallèle une étape 100 de fabrication du drain thermique, et une étape 200 de fabrication des caloducs, indépendante de l'étape 100. Les cycles de production des caloducs d'une part et du drain thermique d'autre part sont donc séparés.

Le dispositif de refroidissement est ensuite intégré au circuit électronique 300. Au cours de cette étape, on fixe le drain thermique sur la carte électronique 301, puis on assemble 302 le drain thermique, les caloducs et les capots protecteurs.

Ce mode de mise en oeuvre a pour avantage de faciliter la maintenance, la réparation ainsi que le stockage des différents éléments constitutifs du dispositif de refroidissement, en raison notamment des cycles de production séparés des caloducs et du drain thermique et d'un assemblage de ces éléments seulement au moment de leur intégration sur la carte électronique.

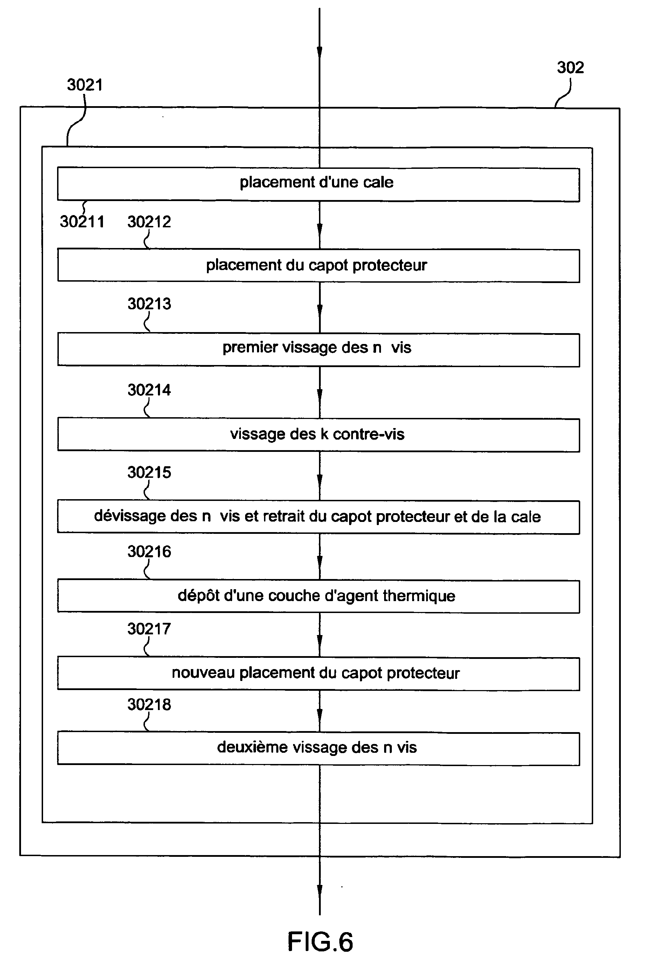

La figure 6 illustre plus précisément l'étape d'assemblage 302, et en particulier une étape 3021 de placement du capot échangeur au-dessus du composant, sur le drain thermique.

Le mode de mise en oeuvre de cette étape 3021 permet de placer systématiquement le capot échangeur à la distance choisie du composant. En effet, dans un mode de fabrication classique, le capot échangeur est placé approximativement à une certaine distance du composant, la valeur de cette distance variant plus ou moins d'un circuit à l'autre voire d'un composant à l'autre.

Le mode de mise en oeuvre de cette étape 3021 prise isolément, peut être appliqué à un dispositif de refroidissement classique, par exemple celui décrit dans le document US 6.839.235.

L'étape 3021 comprend une première sous étape 30211 où l'on place une cale au-dessus du composant. La hauteur de cette cale correspond à la distance à laquelle on souhaite placer le capot du composant. Cette distance peut être par exemple égale à 0,2mm. La cale peut avoir une certaine élasticité de façon à ne pas endommager le composant.

Puis on place le capot échangeur au-dessus de cette cale 3022.

On effectue un premier vissage du capot échangeur sur le drain thermique à l'aide de n vis (4 dans cet exemple) 30213. Ce premier vissage est de préférence relativement léger, les n vis devant être ôtées par la suite.

On procède alors à un vissage de k contre-vis 30214 (dans cet exemple k est égal à 4), les k contre-vis traversant le capot échangeur et prenant appui sur le drain thermique de façon à maintenir le capot échangeur éloigné de la hauteur de la cale du composant.

Les 4 vis sont alors dévissées et le capot échangeur puis la cale sont retirés 30215.

On dépose alors sur la surface découverte du composant une couche d'agent thermique 30216, la hauteur de cette couche correspondant à la hauteur de la cale, ici 0,2 mm.

On replace le capot échangeur au-dessus du composant 30217, la couche d'agent thermique étant intercalée entre ces deux éléments. Les 4 contre-vis fixées dans le capot échangeur le maintiennent à la distance voulue du composant (0,2 mm dans cet exemple).

On procède alors à un deuxième vissage des 4 vis qui avaient préalablement été retirées 30218. Ce deuxième vissage est plus serré que le premier vissage.

## Revendications

1. Dispositif (DIS) de refroidissement d'une carte électronique (CEL) comportant au moins un composant (CMP) recouvert d'un capot échangeur (CPT), le dispositif (DIS) comprenant un drain thermique (DTH) recouvrant tout ou une partie de la carte électronique (CEL), et au moins un caloduc (CAL1, CAL2, CAL3, CAL4) par composant (CMP), chaque caloduc étant apte à évacuer la chaleur du composant auquel il est associé, vers au moins une extrémité de la carte électronique (CEL) via une zone du caloduc dite de condensateur (CND1, CND2, CND3, CND4), ledit dispositif (DIS) étant **caractérisé par le fait qu'**il comprend au moins une pièce d'échange thermique (PE) localisée sur ladite extrémité de la carte électronique (CEL) et montée librement sur le drain thermique (DTH), chaque caloduc (CAL1, CAL2, CAL3, CAL4) étant fixé sur la pièce d'échange thermique (PE) par l'intermédiaire de sa zone de condensateur (CND1, CND2, CND3, CND4).

2. Dispositif selon la revendication précédente, dans lequel la pièce d'échange thermique (PE) est montée sur le drain thermique à l'aide de plots (PLT).

3. Dispositif selon l'une des revendications précédentes, dans lequel chaque pièce d'échange thermique (PE) et la portion du drain thermique (DTH) qu'elle recouvre forment une glissière thermique (GLI), apte à être introduite dans un rail de guidage (RK) monté sur un châssis externe à la carte (CEL).

4. Dispositif selon la revendication précédente, dans lequel un système de verrouillage (SVER) est monté sur chaque glissière thermique (GLI), chaque système de verrouillage (SVER) étant décomposé en au moins une partie fixe (PF) et au moins une partie mobile (PM), lesdites parties fixes (PF) étant formées à partir du drain thermique (DTH).

5. Dispositif selon l'une des revendications précédentes, dans lequel chaque composant (CMP) est associé à au moins deux caloducs, répartis de part et d'autre du composant.

6. Dispositif selon la revendication précédente, dans lequel chaque composant (CMP) est associé à au moins deux caloducs, disposés du même côté du composant (CMP).

7. Dispositif selon la revendication 6, dans lequel au moins deux caloducs associés à un même composant (CMP) sont orientés dans deux directions opposées selon un premier axe (+Y/-Y).

8. Dispositif selon l'une des revendications 6 à 7, dans lequel au moins deux caloducs associés à un même composant (CMP) comprennent chacun une déformation en forme de L, une branche du L étant sensiblement parallèle à l'extrémité de la carte électronique où est localisée la pièce d'échange thermique (PE)" les courbures de la déformation de chaque caloduc étant orientées dans deux directions opposées selon un deuxième axe (+X/-X), parallèle à ladite extrémité de la carte électronique.

9. Dispositif selon l'une des revendications 6 à 8, dans lequel au moins deux caloducs associés à un même composant (CMP) comprend une déformation en forme de U, les branches de chaque U étant sensiblement parallèles à l'extrémité de la carte électronique où est localisée la pièce d'échange thermique (PE), les déformations des caloducs étant orientées dans deux directions opposées selon un deuxième axe (+X/-X), parallèle à ladite extrémité de la carte électronique.

10. Dispositif selon l'une des revendications précédentes, dans lequel chaque capot échangeur (CPT) est fixé au drain thermique (DTH) à l'aide de n vis (VS), et est maintenu à une distance choisie et fixée du composant (CMP) auquel il est associé à l'aide de k contre-vis (CTV), n et k étant des entiers.

11. Circuit électronique (CIR) incorporant une carte électronique (CEL) associée à un dispositif de refroidissement selon l'une des revendications précédentes.

12. Procédé de fabrication d'un dispositif de refroidissement selon l'une des revendications 1 à 10, **caractérisé par le fait qu'**il comprend une étape de fabrication du drain thermique (100) et une étape de fabrication des caloducs (200), indépendante de l'étape de fabrication du drain thermique, puis une étape d'intégration du dispositif de refroidissement au sein du circuit électronique (300) comprenant une fixation du drain thermique sur la carte électronique (301) et un assemblage du drain thermique, des caloducs et des capots protecteurs (302).

13. Procédé selon la revendication précédente, dans lequel l'assemblage du drain thermique, des caloducs et des capots protecteurs comprend pour chaque composant dudit ensemble, un montage du capot échangeur du composant considéré sur le drain thermique (3021), le montage comportant pour chaque composant :
- un placement (3021) d'une cale sur ledit composant, la cale ayant une hauteur choisie et fixée correspondant à ladite distance à laquelle le capot échangeur est maintenu éloigné du composant,
- un placement (30212) du capot échangeur sur le composant correspondant, la cale étant intercalée entre le composant et le capot échangeur correspondant,
- un premier vissage (30213) des n vis, lesdites vis traversant le capot échangeur et une partie de l'épaisseur du drain thermique,
- un vissage (30214) des k contre-vis, lesdites contre-vis traversant le capot échangeur et s'appuyant sur le drain thermique,
- un dévissage (30215) des n vis puis un retrait du capot échangeur et de la cale,
- un dépôt (30216) d'une couche d'agent thermique au dessus du composant,
- un nouveau placement (30217) du capot échangeur au dessus du composant, l'agent thermique étant intercalé entre le composant et le capot échangeur correspondant,
- un deuxième vissage (30218) des n vis, plus serré que le premier vissage, les k contre-vis maintenant le capot échangeur à ladite distance choisie et fixée du composant.

## Claims

1. A device (DIS) for cooling an electronic circuit board (CEL) comprising at least one component (CMP) covered with an exchanger cover (CPT), the device (DIS) comprising a heat sink (DTH) covering all or some of the electronic circuit board (CEL), and at least one heat pipe (CAL1, CAL2, CAL3, CAL4) per component (CMP), each heat pipe being capable of carrying away the heat from the component with which it is associated to at least one end of the electronic circuit board (CEL) via a zone of the heat pipe called the condensing zone (CND1, CND2, CND3, CND4), said device (DIS) being **characterized in that** it comprises at least one heat-exchange part (PE) located on said end of the electronic circuit board (CEL) and mounted freely on the heat sink (DTH), each heat pipe (CAL1, CAL2, CAL3, CAL4) being attached to the heat-exchange part (PE) by means of its condensing zone (CND1, CND2, CND3, CND4).

2. The device as claimed in the preceding claim, wherein the heat-exchange part (PE) is mounted on the heat sink with the aid of pads (PLT).

3. The device as claimed in one of the preceding claims, wherein each heat-exchange part (PE) and the portion of the heat sink (DTH) that it covers form a heat slide (GLI) capable of being inserted into a guide rail (RK) mounted on a frame external to the circuit board (CEL).

4. The device as claimed in the preceding claim, wherein a locking system (SVER) is mounted on each heat slide (GLI), each locking system (SVER) being divided into at least one fixed portion (PF) and at least one movable portion (PM), said fixed portions (PF) being formed from the heat sink (DTH).

5. The device as claimed in one of the preceding claims, wherein each component (CMP) is associated with at least two heat pipes distributed on either side of the component.

6. The device as claimed in the preceding claim, wherein each component (CMP) is associated with at least two heat pipes placed on the same side of the component (CMP).

7. The device as claimed in claim 6, wherein at least two heat pipes associated with one and the same component (CMP) are oriented in two opposite directions on a first axis (+Y/-Y).

8. The device as claimed in one of claims 6 or 7, wherein at least two heat pipes associated with one and the same component (CMP) each comprise an L-shaped deformation, one branch of the L being substantially parallel to the end of the electronic circuit board where the heat-exchange part (PE) is located, the curves of the deformation of each heat pipe being oriented in two opposite directions on a second axis (+X/-X), parallel to said end of the electronic circuit board.

9. The device as claimed in one of claims 6 to 8, wherein at least two heat pipes associated with one and the same component (CMP) comprise a U-shaped deformation, the branches of each U being substantially parallel to the end of the electronic circuit board where the heat-exchange part (PE) is located, the deformations of the heat pipes being oriented in two opposite directions on a second axis (+X/-X), parallel to said end of the electronic circuit board.

10. The device as claimed in one of the preceding claims, wherein each exchanger cover (CPT) is attached to the heat sink (DTH) with the aid of n screws (VS), and is held at a chosen and fixed distance from the component (CMP) with which it is associated with the aid of k check screws (CTV), n and k being whole numbers.

11. An electronic circuit (CIR) incorporating an electronic circuit board (CEL) associated with a cooling device as claimed in one of the preceding claims.

12. A method for fabricating a cooling device as claimed in one of claims 1 to 10, **characterized in that** it comprises a step of fabricating the heat sink (100) and a step of fabricating the heat pipes (200), independent of the step of fabricating the heat sink, then a step of integrating the cooling device into the electronic circuit (300) comprising an attachment of the heat sink to the electronic circuit board (301) and an assembly of the heat sink, the heat pipes and the protective caps (302).

13. The method as claimed in the preceding claim, wherein the assembly of the heat sink, the heat pipes and the protective caps comprises, for each component of said assembly, a mounting of the exchanger cover of the component in question onto the heat sink (3021), the mounting comprising, for each component:
- a placement (3021) of a spacer on said component, the spacer having a chosen and fixed height corresponding to said distance at which the exchanger cover is held away from the component,
- a placement (30212) of the exchanger cover onto the corresponding component, the spacer being inserted between the component and the corresponding exchanger cover,
- a first screwing (30213) of the n screws, said screws passing through the exchanger cover and a portion of the thickness of the heat sink,
- a screwing (30214) of the k check screws, said check screws passing through the exchanger cover and resting on the heat sink,
- an unscrewing (30215) of the n screws and then a removal of the exchanger cover and of the spacer,
- a deposition (30216) of a layer of thermal agent over the component,
- a new placement (30217) of the exchanger cover over the component, the thermal agent being inserted between the component and the corresponding exchanger cover,
- a second screwing (30218) of the n screws, tighter than the first screwing, the k check screws holding the exchanger cover at said chosen and fixed distance from the component.

## Patentansprüche

1. Vorrichtung (DIS) zur Kühlung einer Elektronikkarte (CEL), die mindestens ein Bauteil (CMP) aufweist, das von einer Wärmetauscherabdeckung (CPT) bedeckt ist, wobei die Vorrichtung (DIS) eine Wärmesenke (DTH) umfasst, die die ganze oder einen Teil der Elektronikkarte (CEL) bedeckt, und mindestens ein Heizrohr (CAL1, CAL2, CAL3, CAL4) je Bauteil (CMP), wobei jedes Heizrohr imstande ist, die Wärme des Bauteils, dem es zugeordnet ist, zu mindestens einem Ende der Elektronikkarte (CEL) über eine Zone des Heizrohrs, die als Kondensator (CND1, CND2, CND3, CND4) bezeichnet wird, abzuleiten, wobei die Vorrichtung (DIS) **dadurch gekennzeichnet ist, dass** sie mindestens ein Wärmeaustauschteil (PE) umfasst, das auf dem Ende der Elektronikkarte (CEL) lokalisiert und frei auf der Wärmesenke (DTH) montiert ist, wobei jedes Heizrohr (CAL1 ,CAL2, CAL3, CAL4) über seine Kondensatorzone (CND1, CND2, CND3, CND4) auf dem Wärmeaustauschteil (PE) befestigt ist.

2. Vorrichtung nach vorangehendem Anspruch, wobei das Wärmeaustauschteil (PE) auf der Wärmesenke mit Hilfe von Stiften (PLT) montiert ist.

3. Vorrichtung nach einem der vorangehenden Ansprüche, wobei jedes Wärmeaustauschteil (PE) und der Abschnitt der Wärmesenke (DTH), den es bedeckt, eine thermische Rinne (GLI) bilden, die imstande ist, in eine Führungsschiene (RK) eingeführt zu sein, die auf einem externen Rahmen der Karte (CEL) montiert ist.

4. Vorrichtung nach vorangehendem Anspruch, wobei ein Verriegelungssystem (SVER) auf jeder thermischen Rinne (GLI) montiert ist, wobei jedes Verriegelungssystem (SVER) in mindestens einen starren Teil (PF) und mindestens einen bewegbaren Teil (PM) gegliedert ist, wobei die starren Teile (PF) ausgehend von der Wärmesenke (DTH) gebildet sind.

5. Vorrichtung nach einem der vorangehenden Ansprüche, wobei jedes Bauteil (CMP) mindestens zwei Heizrohren zugeordnet ist, die auf der einen und der anderen Seite des Bauteils verteilt sind.

6. Vorrichtung nach vorangehendem Anspruch, wobei jedes Bauteil (CMP) mindestens zwei Heizrohren zugeordnet ist, die auf derselben Seite des Bauteils (CMP) angeordnet sind.

7. Vorrichtung nach Anspruch 6, wobei mindestens zwei Heizrohre, die einem selben Bauteil (CMP) zugeordnet sind, in zwei entgegengesetzten Richtungen gemäß einer ersten Achse (+Y/-Y) ausgerichtet sind.

8. Vorrichtung nach einem der Ansprüche 6 bis 7, wobei mindestens zwei Heizrohre, die einem selben Bauteil (CMP) zugeordnet sind, jeweils eine L-förmige Deformation aufweisen, wobei ein Arm des L etwa parallel zum Ende der Elektronikkarte ist, wo das Wärmeaustauschteil (PE) lokalisiert ist, wobei die Deformationskrümmungen jedes Heizrohrs in zwei entgegengesetzten Richtung gemäß einer zweiten Achse (+X/-X) ausgerichtet sind, die parallel zum Ende der Elektronikkarte ist.

9. Vorrichtung nach einem der Ansprüche 6 bis 8, wobei mindestens zwei Heizrohre, die einem selben Bauteil (CMP) zugeordnet sind, eine U-förmige Deformation aufweisen, wobei die Arme jedes U etwa parallel zum Ende der Elektronikkarte sind, wo das Wärmeaustauschteil (PE) lokalisiert ist, wobei die Deformationskrümmungen der Heizrohre in zwei entgegengesetzten Richtung gemäß einer zweiten Achse (+X/-X) ausgerichtet sind, die parallel zum Ende der Elektronikkarte ist.

10. Vorrichtung nach einem der vorangehenden Ansprüche, wobei jede Wärmetauscherabdeckung (CPT) an der Wärmesenke (DTH) mit Hilfe von n Schrauben (VS) befestigt ist und mit Hilfe k Gegenschrauben (CTV) in einem ausgewählten und festgelegten Abstand vom Bauteil (CMP), dem sie zugeordnet ist, gehalten wird, wobei n und k ganze Zahlen sind.

11. Elektronikkreis (CIR) mit einer Elektronikkarte (CEL), die einer Kühlvorrichtung nach einem der vorangehenden Ansprüche zugeordnet ist.

12. Verfahren zur Herstellung einer Kühlvorrichtung nach einem der Ansprüche 1 bis 10, **dadurch gekennzeichnet, dass** es einen Schritt der Herstellung der Wärmesenke (100) und einen Schritt der Herstellung der Heizrohre (200) umfasst, der vom Schritt der Herstellung der Wärmesenke unabhängig ist, dann einen Schritt der Integration der Kühlvorrichtung in den Elektronikkreis (300), der eine Befestigung der Wärmesenke auf der Elektronikkarte (301) und eine Montage der Wärmesenke, der Heizrohre und der Schutzabdeckungen (302) umfasst.

13. Verfahren nach vorangehendem Anspruch, wobei die Montage der Wärmesenke, der Heizrohre und der Schutzabdeckungen für jedes Bauteil der Gruppe eine Montage der Wärmetauscherabdeckung des entsprechenden Bauteils auf der Wärmesenke (3021) umfasst, wobei die Montage für jedes Bauteil aufweist:
- eine Platzierung (3021) eines Keils auf dem Bauteil, wobei der Keil eine ausgewählte und festgelegte Höhe hat und entsprechend dem Abstand befestigt ist, in dem die Wärmetauscherabdeckung vom Bauteil entfernt gehalten wird,
- eine Platzierung (30212) der Wärmetauscherabdeckung auf dem entsprechenden Bauteil, wobei der Keil zwischen dem Bauteil und der entsprechenden Wärmetauscherabdeckung zwischengestellt ist,
- eine erste Verschraubung (30213) der n Schrauben, wobei die Schrauben die Wärmetauscherabdeckung und einen Teil der Dicke der Wärmesenke durchqueren,
- eine Verschraubung (30214) der k Gegenschrauben, wobei die Gegenschrauben die Wärmetauscherabdeckung durchqueren und sich auf der Wärmesenke abstützen,
- ein Abschrauben (30215) der n Schrauben und danach ein Abnehmen der Wärmetauscherabdeckung und des Keils,
- ein Aufbringen (30216) einer Schicht eines thermischen Mittels auf das Bauteil,
- eine erneute Platzierung (30217) der Wärmetauscherabdeckung auf dem Bauteil, wobei das thermische Mittel zwischen dem Bauteil und der entsprechenden Wärmetauscherabdeckung zwischengestellt ist,
- eine zweite, festere Verschraubung (30218) der n Schrauben als bei der ersten Verschraubung, wobei die k Gegenschrauben die Wärmetauscherabdeckung in dem ausgewählten und festgelegten Abstand des Bauteils halten.
